Europäisches Patentamt

European Patent Office

Office européen des brevets

(11) Numéro de publication: **0 342 096**
**A1**

## (12) DEMANDE DE BREVET EUROPEEN

(21) Numéro de dépôt: 89401223.6

(22) Date de dépôt: 28.04.89

(51) Int. Cl.⁴: **G 11 C 27/04**
**H 03 K 5/15**

(30) Priorité: 10.05.88 FR 8806281

(43) Date de publication de la demande:
15.11.89 Bulletin 89/46

(84) Etats contractants désignés: DE ES GB IT

(71) Demandeur: **THOMSON VIDEO EQUIPEMENT**
**17, rue du Petit Albi**
**F-95800 Cergy Saint Christophe (FR)**

(72) Inventeur: **Dujardin, Stéphane**
**THOMSON-CSF SCPI**
**F-92045 Paris La Défense Cédex 67 (FR)**

(74) Mandataire: **Turlèque, Clotilde et al**
**THOMSON-CSF SCPI**
**F-92045 PARIS LA DEFENSE CEDEX 67 (FR)**

(54) **Circuit générateur et séquenceur de signaux logiques pour dispositif à transfert de charges.**

(57) Ce circuit est essentiellement constitué par un circuit du type composant logique programmable (de préférence reprogrammable) recevant en entrée un signal d'horloge (CK) de référence et configuré de manière à délivrer en sortie la pluralité de signaux logiques de commande d'horloge (Ø1... ØN) nécessaires à la commande du dispositif à transfert de charges. Il s'agit notamment d'un composant logique programmable configuré de manière à comprendre, autour d'un bus global commun :
- des premiers moyens générateurs de signaux synchronisés (D1,CH), recevant en entrée ledit signal d'horloge (CK) et appliquant en sortie sur le bus global une succession de premières configurations binaires (H) représentatives du séquencement horizontal du dispositif à transfert de charges,
- des seconds moyens générateurs de signaux synchronisés (D2,D3,CV), ·recevant en entrée un signal correspondant à l'apparition d'une configuration binaire particulière parmi lesdites premières configurations binaires, et appliquant en sortie sur le bus global une succession de secondes configurations binaires (V) représentatives du séquencement vertical du dispositif à transfert de charges,
- une pluralité de moyens séquenceurs (DB,DB',B) disposés en parallèle sur le bus global, ces moyens séquenceurs recevant en entrée les signaux présents sur le bus global et décodant ces signaux de manière à générer respectivement, à un instant donné fonction desdites configurations binaires (H,V) et dudit signal d'horloge (CK), l'un desdits signaux logiques de commande (Ø).

FIG.3

Bundesdruckerei Berlin

## Description

### Circuit générateur et séquenceur de signaux logiques pour dispositif à transfert de charges

Le présente invention concerne un circuit générateur et séquenceur de signaux logiques pour dispositifs à transfert de charges.

Les dispositifs à transfert de charges ont besoin, pour leur pilotage, de recevoir un nombre relativement important de signaux logiques de commande, présentant un séquencement temporel bien précis aussi bien en ce qui concerne les instants respectifs où sont produites les impulsions formant ces signaux logiques que les phases respectives de celles-ci.

Ces signaux logiques de commande servent notamment à réaliser le transfert des charges à l'intérieur du capteur matriciel (transfert horizontal, transfert vertical, transfert du plan image au plan mémoire,...), la délivrance du signal de sortie avec un cadencement précis et en fonction d'un signal de synchronisation externe, les remises à zéro,...Ce sont ces signaux que l'on désignera par la suite sous le terme général de "signaux logiques de commande".

Le nombre et les caractéristiques de ces signaux dépendent à la fois de la famille de capteur utilisée (à transfert de trame, à transfert de lignes,...) et, à l'intérieur d'une même famille, du mode de pilotage utilisé pour le transfert des charges, qui peut être très variable d'un fabricant à l'autre, et même d'une référence de circuit à l'autre, pour un même fabricant.

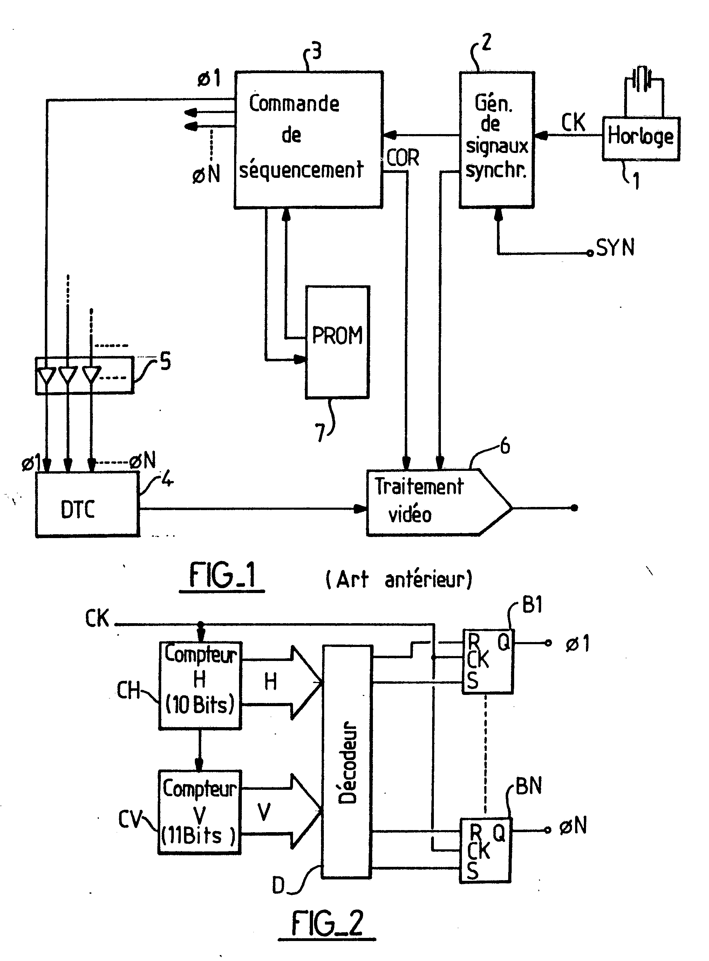

Jusqu'à présent, ces signaux logiques de commande étaient produits par un ensemble de circuits spécialisés dont le schéma est représenté, de façon simplifiée, à la figure 1.

Une horloge 1, généralement à quartz, produit un signal d'horloge de référence CK, de l'ordre de 8 à 15 MHz, appliqué à un générateur de signaux synchronisés 2 qui reçoit également une impulsion de synchronisation extérieure SYN destinée à la synchronisation des trames successives, ce signal SYN étant généralement un signal à 50 ou 60 Hz.

Le signal de sortie du générateur de signaux synchronisés 2 est appliqué en entrée à un circuit de commande de séquencement 3 qui produit les différents signaux logiques de commande Ø1... ØN nécessaires au pilotage du dispositif à transfert de charges 4, par l'intermédiaire d'un étage"driver" 5 qui assure l'adaptation des niveaux de tension et de courant en fonction des besoins du dispositif à transfert de charges.

En effet, la commande de séquencement produit généralement des signaux de type TTL, c'est-à-dire dont les deux niveaux logiques correspondent à 0 et 5 volts, tensions qui ne sont pas celles dont a besoin le capteur pour fonctionner ; en outre, le courant appelé par le capteur est en général très supérieur aux possibilités du circuit logique de séquencement, habituellement un circuit en technologie MOS.

En outre, les dispositifs à transfert de charges comprenant généralement un certain nombre de pixels défectueux, on corrige ces défauts de manière à les rendre invisibles (par exemple en reproduisant, pour le pixel défectueux, le niveau de tension correspondant à l'éclairement du pixel immédiatement précédent).

Cette correction est effectuée, sur commande du circuit de séquencement 3, par le circuit 6 assurant le traitement du signal vidéo délivré en sortie du capteur 4. A cet effet, les positions des pixels défectueux ont été préalablement mémorisées dans une mémoire extérieure 7, généralement une PROM livrée en même temps que le capteur dont elle mémorise les défauts.

Le circuit 3 de commande de séquencement est relié à la PROM 7 par un bus d'adresses et un bus de données et, à chaque ligne, il interroge la PROM pour savoir s'il existe sur cette ligne un défaut et, dans l'affirmative, quelle est la position horizontale de ce pixel défectueux. Il délivrera alors au moment voulu le signal COR au circuit de traitement vidéo 6 (on notera à cet égard que l'on ne peut ainsi mémoriser qu'un seul pixel défectueux par ligne, ce qui est généralement suffisant mais oblige à éliminer par un tri préalable les capteurs ne répondant pas à cette condition).

Ces circuits de l'art antérieur présentent un certain nombre d'inconvénients.

Tout d'abord, comme on le comprendra aisément, le circuit de commande de séquencement est un circuit spécifique à un capteur particulier (par exemple, pour un capteur de type Sony ICX021L, le circuit de commande de séquencement correspondant sera le CX23047A, associé à un générateur de signaux synchronisés CX7930 et à une PROM MB6052).

On voit donc que, puisqu'il s'agit de composants dédiés, il faudra autant de types différents de cartes de synchronisation et de cadencement que l'on utilisera de types différents de capteurs.

En outre, ces cartes sont, à l'échelle du capteur, relativement volumineuses dans la mesure où il faut prévoir plusieurs circuits discrets différents (les circuits 2, 3 et 7) avec leurs interconnexions respectives.

En outre, il ne serait pas possible de réunir en un composant intégré unique les circuits 2, 3 et 7 car la mémoire 7 contient une programmation spécifique associée à un exemplaire donné de capteur, et il est toujours nécessaire que la PROM reste séparée du reste du circuit afin de pouvoir procéder à son échange si par exemple on procède à un échange du capteur.

La présente invention se propose de pallier ces inconvénients, en proposant un circuit générateur et séquenceur de signaux logiques pour dispositifs à transfert de charges qui, non seulement, intègre en un boîtier unique les différentes fonctions nécessaires au pilotage du dispositif à transfert de charges, mais encore soit de conception universelle c'est-à-dire que, à la différence des circuits dédiés de l'art antérieur, le circuit de la présente invention est compatible avec la quasi-totalité des capteurs existants.

Cette caractéristique particulièrement avantageuse permet de ne disposer que d'une unique carte séquencement/traitement vidéo quel que soit le capteur utilisé, seul l'étage d'adaptation des tensions et des courants (circuit "driver" 5 sur la figure 1) étant spécifique aux capteurs.

En outre, dans une même gamme de capteurs, on pourra passer d'un capteur donné à un autre (par exemple d'un capteur à 550 pixels par ligne à un capteur à 750 pixels par ligne, plus performant) sans pour autant avoir à changer la carte portant le circuit générateur et séquenceur, qu'il suffira de reprogrammer en fonction des nouvelles caractéristiques du capteur utilisé.

On peut d'ailleurs noter, à cet égard, que le circuit de l'invention permet de retrouver l'un des avantages dont on disposait auparavant dans les caméras à tubes, à savoir que l'on pouvait changer de type de tubes sans avoir à changer les circuits de synchronisation de trame et de ligne associés.

A cet effet, selon l'invention, le circuit générateur et séquenceur de signaux logiques pour dispositif à transfert de charges ayant une entrée destinée à recevoir un signal d'horloge (CK) de référence, et comportant des moyens de génération de signaux logiques synchronisés reliés à des moyens de séquencement de ces signaux logiques de manière à délivrer en sortie la pluralité de signaux logiques de commande d'horloge (Ø1...ØN) nécessaires à la commande du dispositif à transfert de charges, est caractérisé en ce que les moyens de génération et de séquencement sont intégrés dans un composant unique du type composant logique programmable - de préférence effaçable et reprogrammable -, la programmation du composant étant effectuée en fonction des caractéristiques du dispositif à transfert de charges utilisé.

Avantageusement, le composant logique programmable est configuré de manière à comprendre, autour d'un bus global commun :

- des premiers moyens générateurs de signaux synchronisés, recevant en entrée ledit signal d'horloge et appliquant en sortie sur le bus global une succession de premières configurations binaires représentatives du séquencement horizontal du dispositif à transfert de charges,

- des seconds moyens générateurs de signaux synchronisés, recevant en entrée un signal correspondant à l'apparition d'une configuration binaire particulière parmi lesdites premières configurations binaires, et appliquant en sortie sur le bus global une succession de secondes configurations binaires représentatives du séquencement vertical du dispositif à transfert de charges, et

- une pluralité de moyens séquenceurs disposés en parallèle sur le bus global, ces moyens séquenceurs recevant en entrée les signaux présents sur le bus global et décodant ces signaux de manière à générer respectivement, à un instant donné fonction desdites configurations binaires et dudit signal d'horloge, l'un desdits signaux logiques de commande.

Très avantageusement, le circuit générateur et séquenceur comporte en outre des moyens détecteurs de défauts recevant en entrée les signaux présents sur le bus global et décodant ces signaux de manière à générer, pour certaines combinaisons prédéfinies correspondant à des positions de pixels défectueux du dispositif à transfert de charges, un signal de correction de défaut délivré au circuit assurant le traitement du signal vidéo produit en sortie du dispositif à transfert de charges.

Grâce à cette dernière caractéristique, il n'est plus nécessaire, comme c'était le cas auparavant, de disposer d'un ensemble figé capteur/mémoire des défauts ; pour un exemplaire donné de capteur, il suffira simplement de programmer le circuit générateur et séquenceur (ou de le reprogrammer, s'il s'agit d'un simple changement de capteur) en fonction de la localisation des défauts, la gestion de ces défauts étant effectuée directement par le circuit de commande de séquencement, et non par interrogation répétée d'une mémoire externe.

D'autres caractéristiques et avantages apparaîtront à la lecture de la description détaillée ci-dessous, faite en référence aux dessins annexés sur lesquels :

- la figure 1, précitée, montre la configuration générale des circuits de pilotage d'un dispositif à transfert de charges, dans la configuration de l'art antérieur,

- la figure 2 illustre le schéma de base selon lequel fonctionne le circuit de la présente invention,

- la figure 3 montre l'organisation interne d'un circuit selon la présente invention.

Selon la présente invention, le circuit générateur et séquenceur est essentiellement formé d'un circuit du type composant logique programmable, très avantageusement du type reprogrammable, composant plus connu sous son appelation PLD (Programmable Logic Device) ou EPLD (Erasable Programmable Logic Device).

Ces circuits comportent un certain nombre de fonctions logiques prédiffusées ou "macrocellules" comportant les fonctions logiques classiques telles que bascules, portes, etc. ; ces macrocellules sont ensuite configurées entre elles par l'utilisateur au moyen de transistors EPROM programmés de manière à réaliser les connexions logiques voulues (le terme "programmable" sera entendu au sens habituel de "inscriptible" qu'on lui donne dans la technologie EPROM ou EEPROM ; ce terme ne doit pas évoquer de logique microprogrammée, mais seulement une logique câblée configurée d'une certaine manière par inscription sélective de certaines données définissant la configuration logique que doit présenter le circuit).

Un "bus global" interne, auquel peuvent être reliées toutes les macrocellules, permet à celles-ci de communiquer entre elles et avec des ports d'entrée/sortie du composant.

Un tel circuit convenant à la mise en oeuvre de l'invention est par exemple le EP1800 de Altera, qui est un circuit à 48 macrocellules, incluant chacune une bascule et un jeu de fonctions logiques élémentaires, pour un total de 2100 portes équivalentes.

Ce composant n'est cependant donné qu'à titre d'illustration et, de façon générale, on pourrait aussi bien utiliser tout type de composant logique programmable comportant au moins 1500 portes logiques équivalentes et au moins 40 bascules RS ; si l'on souhaite incorporer au circuit de l'invention la fonction de détection des défauts, le composant logique programmable devra être de type reprogrammable.

On va maintenant décrire la structure fonctionnelle selon laquelle on a configuré le composant logique programmable.

Le principe essentiel est celui illustré figure 2 : les impulsions d'horloge CK produites par l'horloge externe sont appliquées à un premier compteur CH destiné à assurer le séquencement horizontal du balayage de trame du capteur. Ce registre est par exemple un registre à dix étages, qui délivre donc en sortie une première configuration binaire (symbolisée par le bus H) pouvant prendre 1024 états différents.

Une sortie de ce premier compteur CH, correspondant à la configuration de fin de ligne, attaque un second compteur CV destinée à assurer le séquencement vertical du balayage de trame du capteur. Ce second compteur CV est par exemple un compteur à onze étages, qui délivre donc en sortie une seconde configuration binaire (symbolisée par le bus V) pouvant prendre 2048 états différents.

Les deux configurations logiques H et V sont décodées par un étage D qui permet de commander le positionnement et le dépositionnement d'une série de bascules B1...BN dont les sorties vont constituer les signaux logiques Ø1... ØN de pilotage du dispositif à transfert de charges (le nombre exact des sorties Ø1... ØN dépend en fait du type de composant utilisé). Ces signaux logiques de commande Ø1... ØN comprennent typiquement les horloges de transfert vertical et horizontal (nécessitant deux ou quatre signaux, selon les composants) et les signaux d'horloge de remise à zéro de l'étage de sortie ; d'autres signaux logiques peuvent éventuellement être prévus en fonction des différents cas particuliers.

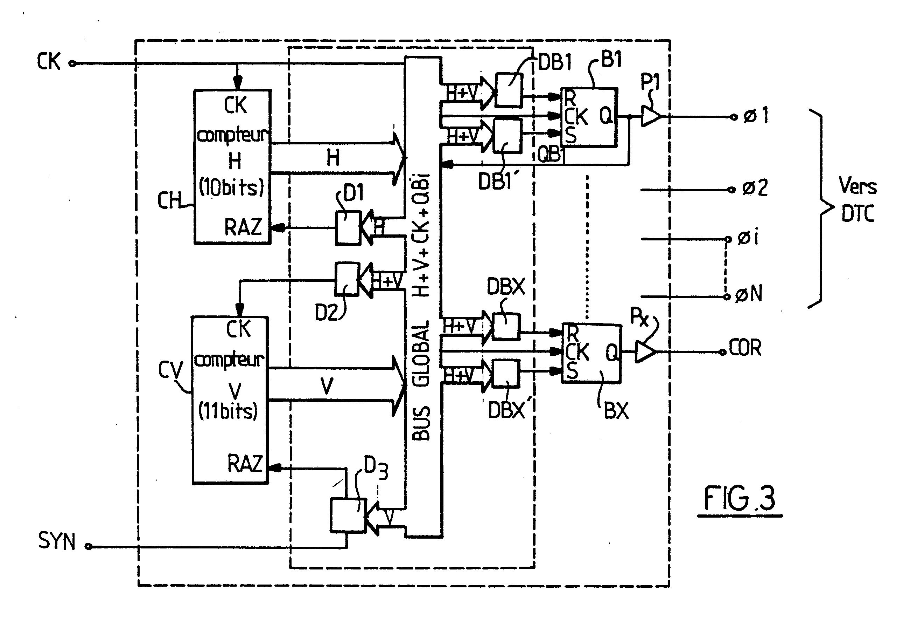

La figure 3 montre plus précisément la manière dont le circuit de la figure 2 est agencé à l'intérieur d'un circuit du type composant logique programmable.

On retrouve les deux compteurs CH et CV qui délivrent les configurations binaires H et V sur un bus global commun à toutes les macrocellules du composant logique programmable.

Le compteur de synchronisation horizontale CH est remis à zéro par une impulsion délivrée à chaque fin de ligne par un étage décodeur D1.

L'étage décodeur D1 étant programmé en fonction du nombre de pixels par ligne, on voit que, si l'on change le capteur pour un capteur comportant un nombre plus élevé de pixels par ligne, il suffit de modifier la programmation de cet étage décodeur D1, sans autre changement.

Le compteur de synchronisation verticale CV est attaqué à son entrée d'horloge par la sortie d'un décodeur D2 similaire en réponse à chaque début d'une nouvelle ligne, et il est remis à zéro par un décodeur D3 en réponse à chaque fin de trame (fonction du nombre de lignes par trame) et également du signal de synchronisation externe SYN.

Les différentes bascules B1... BN sont contrôlées à chacune de leurs entrées R et S par un étage détecteur DB1, DB1',... analysant les signaux présents sur le bus global et recevant sur son entrée CK les impulsions d'horloge, qui transitent également par le bus global.

Les sorties Q des bascules sont appliquées, via un étage adaptateur P1,... aux différentes entrées d'horloge Ø1... ØN du dispositif à transfert de charges.

Les sorties Q des bascules sont également appliquées à des lignes spécifiques du bus de manière à assurer une synchronisation parfaite des différents signaux, respectant exactement leur phase respective.

Très avantageusement, on prévoit également un étage supplémentaire comprenant une bascule BX et des décodeurs associés DBX, DBX' qui délivrent au circuit de traitement vidéo (le circuit 6 de la figure 1), via l'étage PX, un signal COR de correction des défauts.

Dans ce cas, les détecteurs DBX et DBX' sont programmés de façon spécifique pour chaque exemplaire de capteur, en fonction des positions des pixels défectueux préalablement repérées (à la différence des décodeurs D1, D2, D3 et DB1, DB1',... DBN,DBN', qui ne dépendent que du type de capteur et sont donc programmés de la même façon pour tous les exemplaires d'un même type de capteurs).

Si le composant logique programmable est reprogrammable, if suffira de le reprogrammer en cas de remplacement d'un capteur défectueux, sans modification ni échange d'aucun composant.

Il est sera de même si, au sein d'une même famille de capteur, on échange un capteur d'un type donné par un capteur d'un autre type, plus performant (par exemple ayant une définition horizontale supérieure), tout comme l'on procédait naguère pour les capteurs à tubes, pour lesquels il n'y avait pas besoin de modifier les circuits de synchronisation en cas d'échange du tube.

## Revendications

1. Un circuit générateur et séquenceur de signaux logiques pour dispositif à transfert de charges ayant une entrée destinée à recevoir un signal d'horloge (CK) de référence et comportant des moyens de génération de signaux logiques synchronisés reliés à des moyens de séquencement de ces signaux logiques de manière à délivrer en sortie la pluralité de signaux logiques de commande d'horloge (Ø1...ØN) nécessaires à la commande du dispositif à transfert de charges, caractérisé en ce que les moyens de génération et de séquencement sont intégrés dans un composant unique du type composant logique programmable, la programmation du composant étant effectuée en fonction des caractéristiques du dispositif à transfert de charges utilisé.

2. Le circuit générateur et séquenceur de la revendication 1, caractérisé en ce que le composant logique programmable est configuré de manière à comprendre, autour d'un bus global commun :
- des premiers moyens générateurs de signaux synchronisés (D1,CH), recevant en entrée ledit signal d'horloge (CK) et appliquant en sortie sur le bus global une succession de premières configurations binaires (H) représentatives du séquencement horizontal du dispositif à transfert de charges,
- des seconds moyens générateurs de signaux synchronisés (D2,D3,CV), recevant en entrée un signal correspondant à l'apparition d'une configuration binaire particulière parmi lesdites premières configurations binaires, et appliquant en sortie sur le bus global une succession de secondes configurations binaires (V) représentatives du séquencement vertical du dispositif à transfert de charges,
- une pluralité de moyens séquenceurs (DB,DB',B) disposés en parallèle sur le bus global, ces moyens séquenceurs recevant en entrée les signaux présents sur le bus global et décodant ces signaux de manière à générer respectivement, à un instant donné fonction desdites configurations binaires (H,V) et dudit signal d'horloge (CK), l'un desdits signaux logiques de commande (Ø).

3. Le circuit générateur et séquenceur de la revendication 2, caractérisé en ce que le composant logique programmable comporte en outre des moyens détecteurs de défauts (DBX,DBX',BX) recevant en entrée les signaux présents sur le bus global et décodant ces signaux de manière à générer, pour certaines combinaisons prédéfinies correspondant à des positions de pixels défectueux du dispositif à transfert de charges, un signal de correction de défaut (COR) délivré au circuit assurant le traitement du signal vidéo produit en sortie du dispositif à transfert de charges.

4. Le circuit générateur et séquenceur de l'une des revendications 1 à 3, caractérisé en ce que le composant logique programmable est un composant logique programmable effaçable et reprogrammable.

EP 0 342 096 A1

FIG_1     (Art antérieur)

FIG_2

FIG.3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | ELECTRONICS INTERNATIONAL, vol. 50, no. 8, 14 avril 1977, pages 107-108, New York, US; C. BOLON: "Decoders drive flip-flops for clean multiphase clock" * Figures; pages 107-108 * | 1,2,4 | G 11 C 27/04 H 03 K 5/15 |
| Y | US-A-4 431 926 (MAYUMI) * Figures 5,6,7; colonne 1, ligne 48 - colonne 2, ligne 30; colonne 4, lignes 8-55 * | 1,2,4 | |
| A | US-A-4 291 241 (MAYAMA et al.) * Figures 3-5,6,7,13,14; colonne 2, ligne 46 - colonne 3, ligne 24; colonne 4, ligne 24 - colonne 5, ligne 15; colonne 6, ligne 52 - colonne 7, ligne 34 * | 1,2,4 | |
| A | ELECTRONIC DESIGN, vol. 29, no. 16, 6 août 1981, pages 183-190, Waseca, MN., US; A.P. KING et al.: "Charge-coupled devices tackle TV imaging" * Figure 3; page 185, colonne gauche, lignes 27-51 * | 1 | DOMAINES TECHNIQUES RECHERCHES (Int. Cl.4) G 11 C H 03 K |
| A | IBM TECHNICAL DISCLOSURE BULLETIN, vol. 22, no. 6, novembre 1979, pages 2301-2302, New York, US; F.J. AICHELMANN, Jr.: "Bypass selection mechanism for defective chips" | 3 | |
| P,A | PATENT ABSTRACTS OF JAPAN, vol. 13, no. 34 (E-708)[3382], 25th January 1989; & JP-A-63 233 607 (FUJITSU LTD) 29-09-1988 * Figure * | 1 | |

Le présent rapport a été établi pour toutes les revendications

| Lieu de la recherche | Date d'achèvement de la recherche | Examinateur |
|---|---|---|
| LA HAYE | 18-08-1989 | FEUER F.S. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

.............................................................

& : membre de la même famille, document correspondant

EPO FORM 1503 03.82 (P0402)